# EUROPÄISCHE PATENTSCHRIFT

(11) **EP 3 727 705 B1**
(45) Veröffentlichungstag und Bekanntmachung des Hinweises auf die Patenterteilung: **02.08.2023**
(21) Anmeldenummer: 18786697.5
(22) Anmeldetag: 09.10.2018
(51) Int. Cl.: B05D 1/00, C23C 14/50, C23C 16/458, B05C 13/02

(54) **VORRICHTUNG UND VERFAHREN ZUM HERSTELLEN EINER SCHICHT**
DEVICE AND METHOD FOR PRODUCING A LAYER
DISPOSITIF ET PROCÉDÉ DE PRODUCTION D'UNE COUCHE

(30) Priorität: 22.12.2017 DE 102017131047
(43) Veröffentlichungstag der Anmeldung: 28.10.2020
(73) Patentinhaber: Esser, Stefan, 52072 Aachen (DE)
(72) Erfinder: Esser, Stefan, 52072 Aachen (DE)
(74) Vertreter: Bauer, Dirk
(86) Internationale Anmeldenummer: PCT/EP2018/077381
(87) Internationale Veröffentlichungsnummer: WO 2019/120662

(56) Entgegenhaltungen:
- DE-A1- 19 537 218
- JP-A- H05 311 411
- JP-A- 2014 018 257
- JP-B2- 3 275 318

## Beschreibung

Die Erfindung betrifft zunächst eine Vorrichtung zum Herstellen einer Schicht eines Schichtmaterials auf einem sphärischen Substrat mit einer Quelle für das Schichtmaterial, einer Substratstütze, auf der das Substrat aufliegt und einer das Substrat locker umschließenden Substrataufnahme, die eine Bewegung des Substrats in einer horizontalen Ebene begrenzt. Die Erfindung betrifft weiterhin ein Verfahren zum Herstellen einer Schicht eines Schichtmaterials auf einem sphärischen Substrat, das auf einer Substratstütze aufliegt und von einer Substrataufnahme locker umschlossen ist, die eine Bewegung des Substrats in einer horizontalen Ebene begrenzt.

Um den CO2-Ausstoß moderner Motoren zu verringern werden immer mehr Bauteile mit reibungsarmen Verschleißschutzschichten beschichtet. Beschichten ist nach DIN 8580 ein Fertigungsverfahren zum Aufbringen einer festhaftenden Schicht aus formlosem Stoff auf die Oberfläche eines Werkstückes. Ein zu beschichtendes Werkstück wird in der Beschichtungstechnik als "Substrat" bezeichnet. Viele Substrate (insbesondere Massenteile wie beispielsweise Wälzlagerkugeln) sind sehr klein, stellen aber zugleich hohe Anforderungen an die Gleichmäßigkeit der Beschichtung: Oft wird verlangt, dass weniger als 0,3 ppm der Teile einen "Drehfehler" aufweisen. Bei der Oberflächenbehandlung von Wälzlagerkugeln entstehen sowohl durch Halterungen als auch durch aneinander schlagende oder reibende Kugeln unerwünschte Fehlstellen.

US 4,705,298 A schlägt eine Vorrichtung und ein Verfahren der vorgenannten Art vor, wobei eine Wälzlagerkugel in einer Substrataufnahme aus vier senkrechten zylindrischen Stützen gefangen ist, die auf einer waagrechten Platte als Substratstütze montiert sind. Ein Stapel solcher Käfige wird in einer Beschichtungsanlage um eine vertikale Achse verschwenkt und mittels eines vertikal pendelnden Beschichtungskopfes beschichtet.

Die bekannte Vorrichtung ist aufgrund der aufwändigen Montage für die Beschichtung von Massenkleinteilen ungeeignet.

DE 10 2010 001 218 A1 offenbart eine weitere Vorrichtung und ein Verfahren der vorgenannten Art mit hülsenförmigen Substrataufnahmen, in die beispielsweise Düsennadeln oder Steuerkolben gesteckt und auf dem Boden der Substrataufnahme als Substratstütze abgestützt werden.

Diese Vorrichtung ist zur Beschichtung von Substraten ohne ein stabförmiges Ende zum Einstecken in die Substrataufnahme - insbesondere zur Beschichtung von Wälzlagerkugeln - ungeeignet. Weiterer relevanter Stand der Technik ist in den Druckschriften JP H05 311411 A, JP 3 275318 B2 und JP 2014 018257 A offenbart.

Aufgabe Der Erfindung liegt die Aufgabe zugrunde, die Beschichtung von Wälzlagerkugeln zu vereinfachen.

Lösung Die Erfindung wird durch den Gegenstand der unabhängigen Ansprüche 1 und 5 definiert.

Ausgehend von der bekannten Vorrichtung wird nach der Erfindung vorgeschlagen, einen Antrieb zum Bewegen der Substratstütze in der horizontalen Ebene relativ zu der Substrataufnahme vorzusehen. Durch die Relativbewegung der (vertikalen) Substratstütze zu der (seitlichen) Substrataufnahme kann die Substrataufnahme mit der erfindungsgemäßen Vorrichtung fest verbunden werden und lässt sich deutlich einfacher mit den Substraten bestücken. In der erfindungsgemäßen Vorrichtung rollt das Substrat auf der Substratstütze auf einer linienförmigen Kontaktkante ab.

Vorzugsweise begrenzt in einer erfindungsgemäßen Vorrichtung die Substrataufnahme die Bewegung des Substrats in der horizontalen Ebene auf eine Kreisfläche. Die kreisförmige Begrenzung vermeidet Fehlstellen in der aufgetragenen Schicht durch ruckartige Bewegungen und Stöße während der Herstellung.

Vorzugsweise weist eine erfindungsgemäße Vorrichtung einen Tragring und eine unter dem Tragring beweglich gelagerte Taumelscheibe, und eine Vielzahl gleichartiger Käfige auf, wobei jeder der Käfige jeweils aus einer an der Taumelscheibe ausgebildeten Substratstütze und einer an dem Tragring ausgebildeten Substrataufnahme besteht. Eine solche Vorrichtung erlaubt die gleichzeitige Beschichtung einer Vielzahl von Substraten.

Vorzugsweise weist eine solche erfindungsgemäße Vorrichtung einen rotierbaren Exzenter zum Antreiben der Bewegung der Taumelscheibe in der horizontalen Ebene auf. In einer solchen Vorrichtung wird die Taumelscheibe mit den Substratstützen gleichförmig auf einer Kreisbahn bewegt.

Ausgehend von dem bekannten Verfahren wird nach der Erfindung vorgeschlagen, dass die Substratstütze in der horizontalen Ebene relativ zu der Substrataufnahme bewegt wird. Das erfindungsgemäße Verfahren wird insbesondere mit einer erfindungsgemäßen Vorrichtung ausgeführt und zeichnet sich gleichermaßen durch deren vorstehend genannte Vorteile aus. Vorzugsweise wird in einem erfindungsgemäßen Verfahren die Substratstütze auf einer Kreisbahn bewegt. Die kreisförmige Bewegung der Substratstütze vermeidet Fehlstellen in der aufgetragenen Schicht durch Stöße während der Herstellung.

Erfindungsgemäß rollt in einem erfindungsgemäßen Verfahren das Substrat auf der Substratstütze auf einer linienförmigen Kontaktkante ab. Die linienformige Kontaktkante minimiert die Verdeckung des Substrats durch die Substratstütze. Vorzugsweise weist in einem solchen erfindungsgemäßen Verfahren die Kontaktkante eine quer zu der horizontalen Ebene verlaufende Krümmung auf. Beim Abrollen auf der Kontaktkante ändert sich so zusätzlich die vertikale Lage des Substrats in der Substrataufnahme.

Vorzugsweise ist in einem erfindungsgemäßen Verfahren das Substrat eine Wälzlagerkugel. Das erfindungsgemäße Verfahren eignet sich besonders für solche und ähnliche Massenkleinteile.

Vorzugsweise wird in einem erfindungsgemäßen Verfahren die Schicht in einem Gasabscheidungsverfahren hergestellt. Zum Beschichten kleiner, hochpräziser Substrate kommen insbesondere die physikalische Gasphasenabscheidung ("physical vapor deposition"/"PVD") und die plasmaunterstützte chemische Gasphasenabscheidung ("plasma enhanced chemical vapor deposition"/"PECVD") zum Einsatz.

Im PVD-Verfahren ist das "Target" die Platte, die mit geladenen Teilchen beschossen wird. Dadurch wird Targetmaterial verdampft und im Vakuum, typischer Weise zwischen 10 *mPa* und 3000 *mPa* als Schicht auf den relativ kalten Substraten abgeschieden. Häufig wird die Verdampfung durch eine elektrische Entladung herbeigeführt. Hier unterscheidet man die Elektronenstrahlverdampfung (EBPVD electron beam) die Lichtbogenverdampfung (AIP arc ion plating) und die Sputterverfahren (MSIP magnetron sputter ion plating).

Häufig wird auch die Abscheidung durch eine an die Substrate angelegte Spannung beeinflusst. Diese Spannung wird Biasspannung genannt und beeinflusst die Schichteigenschaften, insbesondere die Härte der Schicht. Die Biasspannung kann eine Gleichspannung (DC), eine Wechselspannung (AC, MF, RF) oder eine gepulste Spannung (Unipolar, Bipolar) sein.

Im PECVD Verfahren wird das Schichtmaterial gasförmig der Beschichtungskammer zugeführt. An die Substrate wird eine RF oder gepulste Spannung angelegt, die das Gas aufspaltet und zur Abscheidung eines Teils führt. Der Druck beim PECVD liegt üblicherweise um Faktor 10 bis 100 höher als beim PVD.

Allen PVD-Verfahren gemeinsam ist, dass das Schichtmaterial sich überwiegend geradlinig von der Quelle ausbreitet bzw. teilweise von den elektrischen Feldlinien abgelenkt wird. Hierdurch entstehen in der Ausbreitung des Schichtmaterials Vorzugsrichtungen, so dass Substratflächen, die entgegen dieser Vorzugsrichtungen orientiert sind, eine besonders hohe Abscheiderate aufweisen. Substratflächen, die den Vorzugsrichtungen abgewandt sind, werden kaum beschichtet. Um eine homogene Beschichtung der einzelnen Substrate zu erzielen, werden diese in der Beschichtungskammer um mehrere Achsen gesteuert rotiert.

### Ausführungsbeispiel

Die Erfindung wird nachfolgend anhand eines Ausführungsbeispiels erläutert. Es zeigen
- Fig. 1a: eine perspektivische Ansicht eines Substrattellers einer erfindungsgemäßen Vorrichtung,
- Fig. 1b: eine geschnittene Darstellung des Substrattellers,
- Fig. 1c: eine Explosionsdarstellung des Substrattellers und
- Fig. 1d: eine Draufsicht des Substrattellers,

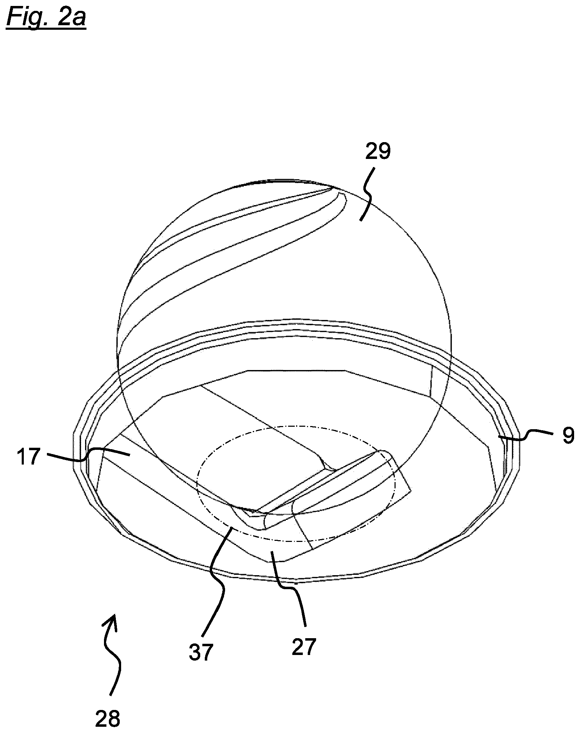

- Fig. 2a: einen einzelnen Käfig des Substrattellers im Detail in einer perspektivischen Ansicht,

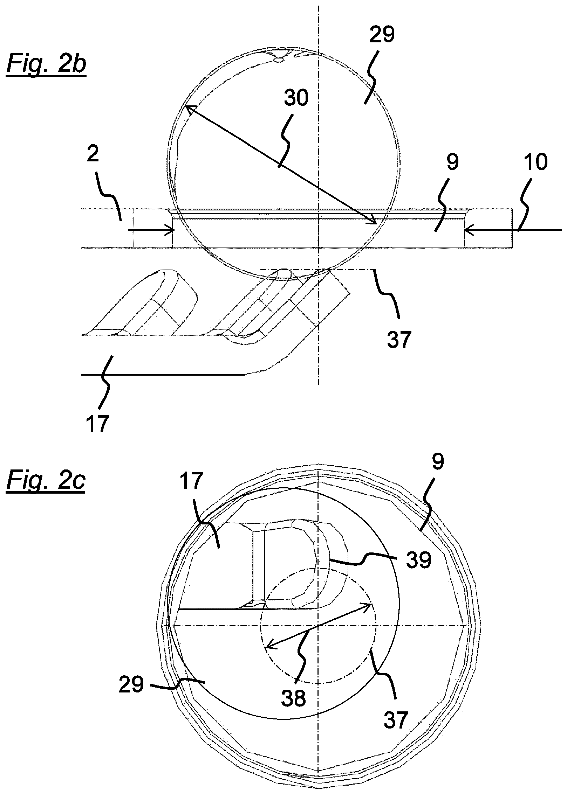

- Fig. 2b: eine geschnittene Seitenansicht des Käfigs, und
- Fig. 2c: eine Draufsicht des Käfigs.

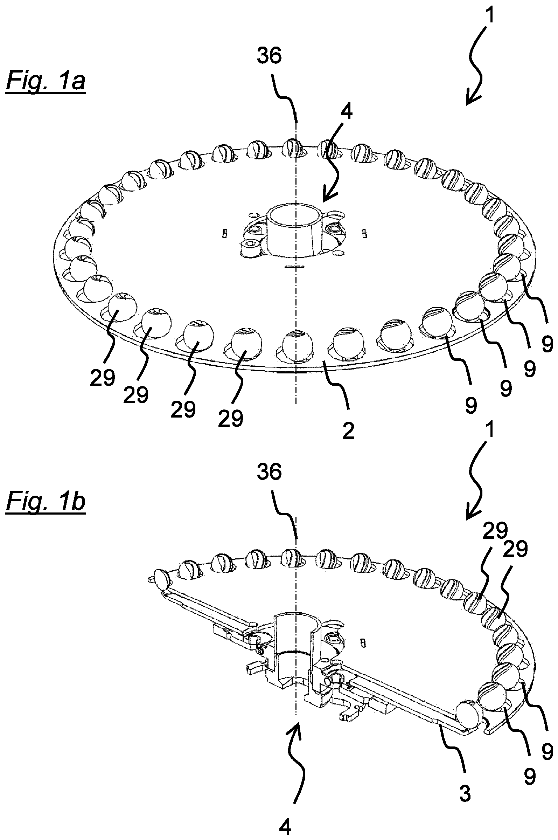

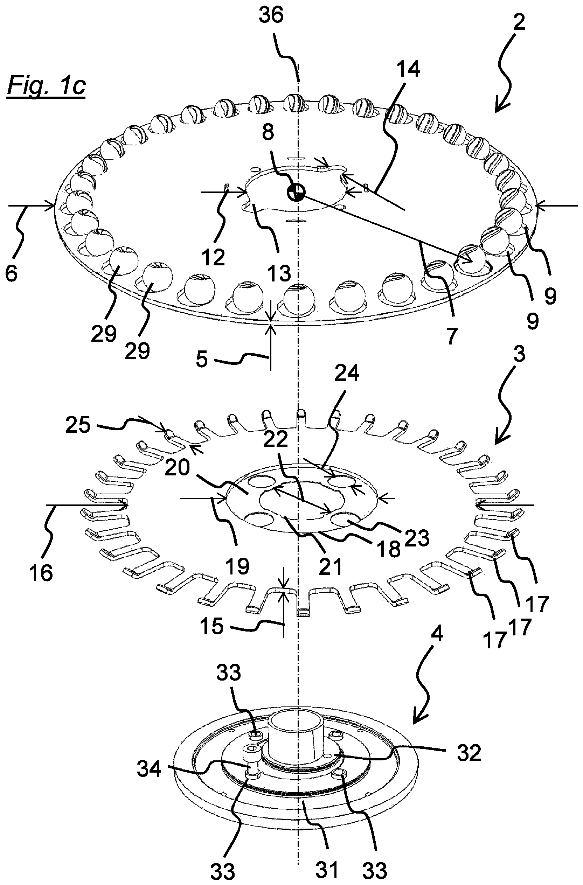

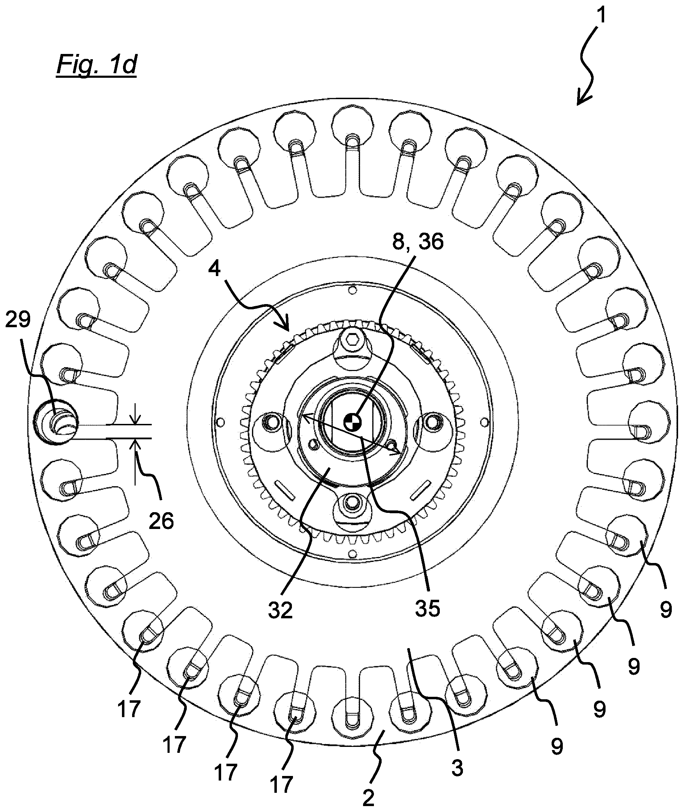

Der in den Figuren 1a bis 1d gezeigte Substratteller 1 einer nicht weiter dargestellten erfindungsgemäßen PVD-Vorrichtung weist einen Tragring 2 und eine Taumelscheibe 3 sowie einen Antrieb 4 für die Taumelscheibe 3 auf.

Der drehsymmetrische Tragring 2 weist eine Dicke 5 von 2 *mm* und einen Durchmesser 6 von 230 *mm* auf, im Abstand 7 von 105 *mm* vom Mittelpunkt 8 befinden sich 32 Durchbrüche als Substrataufnahmen 9 mit einem Durchmesser 10 von 15 *mm.* Der Tragring 2 weist eine zentrale Durchgangsbohrung 11 mit einem Durchmesser 12 von 50 *mm* und zwei daran ansetzenden Taschen 13 mit einem Durchmesser 14 von 10 *mm* auf.

Die drehsymmetrische Taumelscheibe 3 weist eine Dicke 15 von 2 *mm,* einen Durchmesser 16 von 170 *mm* und 32 radial nach außen weisende Substratstützen 17 sowie eine Durchgangsbohrung 18 mit einem Durchmesser 19 von 75 *mm* auf. Die Taumelscheibe 3 ist mit einer Stützscheibe 20 verbunden, die eine Exzenterbohrung 21 mit einem Durchmesser 22 von 39 *mm* und vier Führungsbohrungen 23 mit einem Durchmesser 24 von 14 *mm* aufweist.

Jede Substratstütze 17 weist eine Länge 25 von 21 *mm,* eine Breite 26 von 5 *mm* auf und einen um 4 *mm* gekröpften und gerundeten Kopf 27 auf und bildet mit einer Substrataufnahme 9 im Tragring 2 einen Käfig 28 für ein sphärisches Substrat 29 - hier: Wälzlagerkugeln mit einem Durchmesser 30 von 12 *mm.*

Der Antrieb 4 weist eine kreisförmige Grundplatte 31 auf, in der ein Exzenter 32 drehbar gelagert ist und auf der vier Führungsbuchsen 33 und ein Stützbolzen 34 angebracht sind. Der Exzenter 32 weist einen Durchmesser 35 von 39 *mm* auf und ist gegenüber dem Mittelpunkt 8 um 3,5 *mm* verschoben.

Der Exzenter 32 und die Führungsbuchsen 33 des Antriebs 4 liegen in der Exzenterbohrung 21 und den Führungsbohrungen 23 der Stützscheibe 20 an und übertragen so eine Rotation des Exzenters 32 um eine Hochachse 36 des Substrattellers 1 auf die Taumelscheibe 3. Der Tragring 2 ist durch die in den Taschen 13 anliegenden Stützbolzen 34 mit der Grundplatte 31 um die Hochachse 36 verdrehfest verbunden.

Im Betrieb der erfindungsgemäßen Vorrichtung beschreibt die Taumelscheibe 3 mit den Substratstützen 17 eine Kreisbahn 37 mit einem Durchmesser 38 von 7 *mm* in einer horizontalen Ebene senkrecht zur Hochachse 36. Die Substrate 29 rollen auf einer linienförmigen Kontaktkante 39 am Kopf 27 der Substratstütze 17 ab.

In der erfindungsgemäßen Vorrichtung werden die Substrate 29 in den Substrataufnahmen 9 vereinzelt. Die Substratteller 1 sind auf einem nicht dargestellten Tisch übereinander gestapelt und rotieren um eine Tellerachse. Die Vorrichtung weist einen Durchmesser von 150 *cm* auf und fasst 18 Tische auf einem Kammerboden zusammen. Die Tische werden von einem gemeinsamen zentralen Antrieb des Kammerbodens über ein Antriebsrad angetrieben.

In den Figuren sind
- 1: Substratteller
- 2: Tragring
- 3: Taumelscheibe
- 4: Antrieb
- 5: Dicke
- 6: Durchmesser
- 7: Abstand
- 8: Mittelpunkt
- 9: Substrataufnahme
- 10: Durchmesser
- 11: Durchgangsbohrung
- 12: Durchmesser
- 13: Tasche
- 14: Durchmesser
- 15: Dicke
- 16: Durchmesser
- 17: Substratstütze
- 18: Durchgangsbohrung
- 19: Durchmesser
- 20: Stützscheibe
- 21: Exzenterbohrung
- 22: Durchmesser
- 23: Führungsbohrung
- 24: Durchmesser
- 25: Länge
- 26: Breite
- 27: Kopf
- 28: Käfig
- 29: Substrat
- 30: Durchmesser
- 31: Grundplatte
- 32: Exzenter
- 33: Führungsbuchse
- 34: Stützbolzen
- 35: Durchmesser
- 36: Hochachse
- 37: Kreisbahn
- 38: Durchmesser
- 39: Kontaktkante

## Patentansprüche

1. Vorrichtung zum Herstellen einer Schicht eines Schichtmaterials auf einem sphärischen Substrat (29) mit einer Quelle für das Schichtmaterial, einer Substratstütze (17), auf der das Substrat (29) aufliegt, einer das Substrat (29) locker umschließenden Substrataufnahme (9), die eine Bewegung des Substrats (29) in einer horizontalen Ebene begrenzt und einem Antrieb (4) zum Bewegen der Substratstütze (17) in der horizontalen Ebene relativ zu der Substrataufnahme (9), ***gekennzeichnet durch*** eine linienförmige Kontaktkante (39) der Substratstütze (17), auf der das Substrat (29) abrollt.

2. Vorrichtung nach dem vorgenannten Anspruch, ***dadurch gekennzeichnet, dass*** die Substrataufnahme (9) die Bewegung des Substrats (29) in der horizontalen Ebene auf eine Kreisfläche begrenzt.

3. Vorrichtung nach einem der vorgenannten Ansprüche, ***gekennzeichnet durch*** einen Tragring (2) und eine unter dem Tragring (2) beweglich gelagerte Taumelscheibe (3), und mit einer Vielzahl gleichartiger Käfige (28), wobei jeder der Käfige (28) jeweils aus einer an der Taumelscheibe (3) ausgebildeten Substratstütze (17) und einer an dem Tragring (2) ausgebildeten Substrataufnahme (9) besteht.

4. Vorrichtung nach dem vorgenannten Anspruch, ***gekennzeichnet durch*** einen rotierbaren Exzenter (32) zum Antreiben der Bewegung der Taumelscheibe (3) in der horizontalen Ebene.

5. Verfahren zum Herstellen einer Schicht eines Schichtmaterials auf einem sphärischen Substrat (29), das auf einer Substratstütze (17) aufliegt und von einer Substrataufnahme (9) locker umschlossen ist, die eine Bewegung des Substrats (29) in einer horizontalen Ebene begrenzt, ***dadurch gekennzeichnet, dass*** die Substratstütze (17) in der horizontalen Ebene relativ zu der Substrataufnahme (9) bewegt wird, ***dadurch gekennzeichnet, dass*** das Substrat (29) auf der Substratstütze (17) auf einer linienförmigen Kontaktkante (39) abrollt.

6. Verfahren nach dem vorgenannten Anspruch, ***dadurch gekennzeichnet, dass*** die Substratstütze (17) auf einer Kreisbahn (37) bewegt wird.

7. Verfahren nach einem der Ansprüche 5 oder 6, ***dadurch gekennzeichnet, dass*** die Kontaktkante (39) eine quer zu der horizontalen Ebene verlaufende Krümmung aufweist.

8. Verfahren nach einem der Ansprüche 5 bis 7, ***dadurch gekennzeichnet, dass*** das Substrat (29) eine Wälzlagerkugel ist.

9. Verfahren nach einem der Ansprüche 5 bis 8, ***dadurch gekennzeichnet, dass*** die Schicht in einem Gasabscheidungsverfahren hergestellt wird.

## Claims

1. A device for the production of a layer of a layer material on a spherical substrate (29) with a source for the layer material, a substrate support (17), on which the substrate (29) lies, a substrate holder (9) loosely enclosing the substrate (29), which limits a movement of the substrate (29) in a horizontal plane, and a drive (4) for moving the substrate support (17) in the horizontal plane relative to the substrate holder (9), ***characterised by*** a linear contact edge (39) of the substrate support (17), on which the substrate (29) rolls off.

2. The device according to the preceding claim, ***characterised in that*** the substrate holder (9) limits the movement of the substrate (29) in the horizontal plane on a circular surface.

3. The device according to any one of the preceding claims, ***characterised by*** a support ring (2) and a wobble plate (3) mounted mobile beneath the carrier support (2), and with a plurality of identical cages (28), wherein each of the cages (28) in each consists of a substrate support (17) constituted on the wobble plate (3) and a substrate holder (9) constituted on the support ring (2) .

4. The device according to the preceding claim, ***characterised by*** a rotatable cam (32) for driving the movement of the wobble plate (3) in the horizontal plane.

5. A method for the production of a layer of a layer material on a spherical substrate (29), which lies on a substrate support (17) and is loosely enclosed by a substrate holder (9), which limits a movement of the substrate (29) in a horizontal plane, ***characterised in that*** the substrate support (17) is moved relative to the substrate holder (9) in the horizontal plane, ***characterised in that*** the substrate (29) on the substrate support (17) rolls off on a linear contact edge (39).

6. The method according to the preceding claim, ***characterised in that*** the substrate support (17) is moved on a circular path (37).

7. The method according to any one of claims 5 or 6, ***characterised in that*** the contact edge (39) comprises a curvature running perpendicular to the horizontal plane.

8. The method according to any one of claims 5 to 7, ***characterised in that*** the substrate (29) is a roller ball bearing.

9. The method according to any one of claims 5 to 8, ***characterised in that*** the layer is produced in a gas vapour deposition process.

## Revendications

1. Dispositif de fabrication d'une couche d'un matériau de couche sur un substrat sphérique (29) avec une source pour le matériau de couche, un support de substrat (17), sur lequel repose le substrat (29), un logement de substrat (9) entourant de façon non serrée le substrat (29), qui limite un mouvement du substrat (29) dans un plan horizontal et un système d'entraînement (4) pour déplacer le support de substrat (17) dans le plan horizontal par rapport au logement de substrat (9), **caractérisé par** un bord de contact de forme linéaire (39) du support de substrat (17) sur laquelle roule le substrat (29).

2. Dispositif selon la revendication précédente, **caractérisé en ce que** le logement de substrat (9) limite le mouvement du substrat (29) dans le plan horizontal sur une surface circulaire.

3. Dispositif selon l'une quelconque des revendications précédentes, **caractérisé par** un anneau porteur (2) et un disque oscillant (3) logé de façon mobile sous l'anneau porteur (2) et avec une pluralité de cages (28) identiques, sachant que chacune des cages (28) est respectivement composée d'un support de substrat (17) constitué sur le disque oscillant (3) et d'un logement de substrat (9) constitué sur l'anneau porteur (2).

4. Dispositif selon la revendication précédente, **caractérisé par** un excentrique rotatif (32) pour entraîner le mouvement du disque oscillant (3) dans le plan horizontal.

5. Procédé de fabrication d'une couche d'un matériau de couche sur un substrat sphérique (29), qui repose sur un support de substrat (17) et est entouré de façon non serrée par un logement de substrat (9), qui limite un mouvement du substrat (29) dans un plan horizontal, **caractérisé en ce que** le support de substrat (17) est déplacé dans le plan horizontal par rapport au logement de substrat (9), **caractérisé en ce que** le substrat (29) roule sur le support de substrat (17) sur un bord de contact de forme linéaire (39).

6. Procédé selon la revendication précédente, **caractérisé en ce que** le support de substrat (17) est déplacé sur une piste circulaire (37).

7. Procédé selon l'une quelconque des revendications 5 ou 6, **caractérisé en ce que** le bord de contact (39) comporte une courbure passant transversalement au plan horizontal.

8. Procédé selon l'une quelconque des revendications 5 à 7, **caractérisé en ce que** le substrat (29) est une bille d'un palier à roulement.

9. Procédé selon l'une quelconque des revendications 5 à 8, **caractérisé en ce que** la couche est fabriquée dans un procédé de séparation des gaz.
